(19) **Europäisches Patentamt**
**European Patent Office**
**Office européen des brevets**

(11) **EP 2 284 997 A1**

(12) **EUROPEAN PATENT APPLICATION**

(43) Date of publication:
**16.02.2011 Bulletin 2011/07**

(51) Int Cl.:
*H03H 1/00* (2006.01)   *H03H 7/01* (2006.01)
*H01P 1/201* (2006.01)   *H01P 1/22* (2006.01)

(21) Application number: **09165418.6**

(22) Date of filing: **14.07.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **ABB Research Ltd.**
**8050 Zürich (CH)**

(72) Inventor: **Cottet, Didier**
**CH-8050, Zürich (CH)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(54) **Low pass filter device**

(57)    The invention relates to an electronic power device comprising a low pass filter device of the following type and the damping device or means for damping high frequency alternating current conducted therethrough, the damping device (2, 2', 2", 20, 21, 22, 23, 24, 25) comprising: a main conducting portion (3, 300) with a first end (4.1, 400.1) and a second end (4.2, 400.2) connected by a main axis (4). The damping device (2, 2', 2", 20, 21, 22, 23, 24, 25) further comprises at least one peripheral conducting element (5, 50, 500, 5000) electrically contacting the main conducting portion (3, 300) and protruding away from said main conducting portion (3, 300) respectively between the first end (4.1, 400.1) and the second end (4.2, 400.2) for high frequency AC damping.

Fig. 3

EP 2 284 997 A1

Printed by Jouve, 75001 PARIS (FR)

**Description**

The invention relates to a high frequency damping device according to claim 1 and an electronic power device according to claim 14.

High frequency damping (HFD) technology - in particular high frequency damping bus bar technology - is intended to increase resistivity with increasing frequency and therefore to damp unwanted high frequency noise. Such high frequency noise may origin from switching harmonics of power electronic systems or ringing and oscillations of resonating structures, for example. Low pass damping effects are at least partially based on the conductor's skin- and proximity effects, which are inherent to any conducting structure.

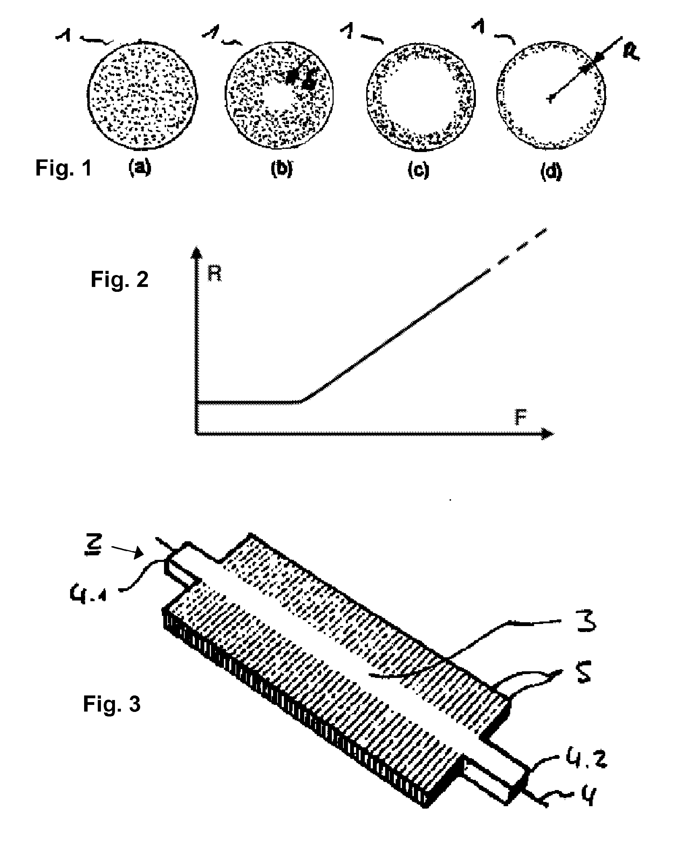

In Fig. 1, the black area shows the current distribution inside a circular conductor 1, with increasing frequency from a) towards d). In a) there is no skin effect visible, in b) the skin effect starts to be visible, in c) the skin effect is already well pronounced, and in d) the current distribution is almost only along the surface of the conductor.

As can be seen from the figures 1 and 2, the effective current conducting cross section is decreasing with frequency, hence the resistance is increasing. The resistance becomes noticeable at a frequency where the skin depth equals the conductor radius (see Fig. 2).

An object has been to increase the damping of high frequency damping. In order to use such damping effects, approaches have been presented earlier, using conductor sandwich layers with special lossy materials. However, increasing the resistivity at the surface of the conductor is only of limited use, since higher resistivity attenuates the skin effect.

$$\delta = \sqrt{\frac{2\rho}{\omega\mu}}$$

$\delta$ = skin depth
$\rho$ = conductor permeability
$\omega$ = angular frequency
$\mu$ = conductor resistivity

It is thus the object of the invention to provide a low pass filter device with an effective mechanical damping means for damping of high frequency alternating currents and an electric power device using such a low pass filter device.

As to the object relating to the low pass filter device the problem is solved by the device having the features of claim 1.

The basic idea of the present invention is to make use of the skin effect and to reroute the high frequency current into longer current paths, and therefore to increase the total path resistance between two terminals of the damping device.

The low pass filter device, hereinafter also referred to as damping device according to the invention is suited for conducting alternating current and/or direct current. The damping device or means is in particular suited for significantly damping high frequency alternating current conducted therethrough without significantly damping low frequency alternating current possibly conducted therethrough. The damping is preferably achieved by means of a "mechanical" damping device or means, which is insofar referred to be "mechanical" as it is not a conventional electrical circuit but rather a mechanical structure having with a specially designed, intelligent shape and size, merely than having a massive conductive structure. The low pass filter device comprises a main conducting portion with a first end and a second end constituting respective terminals and connected to each other by a main axis. At least one peripheral conducting element contacts the main conducting portion and protrudes away from said main conducting portion respectively between the first end and the second end for high frequency AC damping.

By means of the peripheral conducting element, the high frequency current is rerouted into a longer current path as it is only flowing at a surface near area of the conductor due to the skin effect. This leads to an increase of the total path resistance for the high frequency current fraction.

Due to the peripheral conducting element contacting the main conducting portion and protruding away from said main conducting portion, the path the high frequency current fraction takes is enlarged. The high frequency current tends to have highest current densities on the surface region of the damping device comprising the peripheral conducting element contacting the main conducting portion and protruding away from said main conducting portion. This surface region is enhanced by the peripheral conducting element electrically contacting the main conducting portion and protruding away from said main conducting portion. The geometry of said peripheral conducting element is preferably adapted to the frequency and/or frequencies and/or frequency range to be damped most effectively.

Although different conductive materials may be used for each of the different parts of the damping devices or means according to the invention, copper, aluminum and/or alloys therewith may also be used.

A preferred use of the low pass filter device or means according to the present invention is a use in an electric power device comprising at least one low pass filter device that is conductively connected to at least one of an electric and an electronic element.

Other features considered as characteristic for the invention are set forth in the dependent claims.

In one embodiment, the at least one electric power device comprises a transformer outlet and a low frequency alternating current terminal which are electrically connected by the at least one high frequency damping device.

Depending on the requirements, the embodiment of the at least one electric device comprises a power electronic inverter direct current outlet and a direct current link capacitor, which are electrically connected by the at least one high frequency damping device.

The degree of freedom for design variations is comparatively high if the main conducting portion is connected to a plurality of peripheral conducting elements contacting the main conducting portion and protruding away from said main conducting portion respectively between the first end and the second end for high frequency AC damping. Therewith, high frequency damping properties can be enhanced, i.e. are enhanceable, and may be fine tuned in addition depending on specific high frequency damping particularities and requirements. High frequency damping may thus be improved significantly.

In an embodiment, the plurality of peripheral conducting elements forms a periodic pattern for high frequency AC damping. In this case, the periodic pattern allows a very efficient and easy-to-realize fine tuning of the high frequency damping properties.

In a further embodiment, at least one peripheral conducting element is formed as a meander-shaped conducting element for high frequency AC damping. The at least one peripheral conducting element is meander-shaped. In such an embodiment, the meander-shaped conducting element contributes to a particular convenient fine tuning and improving of the high frequency damping properties and surface is further increased without additional space requirement.

In yet a further embodiment, at least one peripheral conducting element is formed as a fin laterally projecting away from the main axis for high frequency AC damping.

A particular economic low pass filter device is achievable if the damping device extends essentially in a plane comprising the main axis. In one embodiment thereof, the damping device is even and formed on a plane comprising the main axis. A plurality of similar and/or equal damping elements each of them being built like the above mentioned damping device may easily be stacked to realize together a damping device for further high frequency damping applications. Higher current cases may thus be handled.

Where suitable, the damping means or element is at least partially integrated into the damping device. Preferably, the damping means is punched out or cut out by a laser cutter. By doing so, the damping means and the damping device are very easily produceable. However, other techniques for producing the required spaced between adjacent fins are formed by milling, sawing, grinding, and eroding, depending on the demands and particularities.

In a basic embodiment, the main conducting portion and the peripheral conducting element are formed by one structural unit. This shape avoids having possible troubles arising from a connection between the main conducting portion and the peripheral conducting element from the start.

In an alternative embodiment, the main conducting portion and the peripheral conducting element are separate structural units. In this case, the peripheral conducting element may be formed independently from the main conducting portion and connected to it afterwards. Complex designs for the independent peripheral conducting element allow a particularly fine tuning and effective damping properties may be realized easily. Such independent peripheral conducting elements may be suitable for a lot of different main conducting portion designs. The degrees of freedom for damping device designs are thus further enhanced.

In one embodiment the peripheral conducting element comprises at least one zigzag shaped conductor sheet. Preferably, the peripheral conducting element comprises a conductor sheet folded for high frequency AC damping. Such conductor sheets are easy to form, e.g. by means of sheet bending, even if designs are complex, and easy to connect to a main conducting portion, e.g. by means of soldering or brazing.

In a further embodiment a plurality of damping elements form a damping device for high frequency AC damping. Further designs of the low pass filter device become thus feasible. Consequently, way more applications can benefit from the aforementioned advantages.

In yet another embodiment, the low pass filter device forms together with at least one further low pass filter device according to the invention a compound damping device with interlacing peripheral conducting elements for high frequency AC damping. The low pass filter device comprises a plurality of damping elements or means with interlacing peripheral conducting elements. With this embodiment, requirements of applications with opposing current directions in the different damping devices may also be met. Interlacing peripheral conducting elements allow effective and space-saving arrangements.

A peripheral conducting element placed between the first end and the second end of a damping device or means may be of different shapes as for example cylindrical, hollow cylindrical, polygonal, hollow polygonal. A mixture of differently shaped peripheral conducting elements may also be used between the first end and the second end of a low pass filter device. The specific geometries and sizes may, as always, be adapted to match special damping and/or cooling property requirements.

The invention will be explained in more detail in the following description with reference to embodiments shown in the figures, in which:

Fig. 1     shows a conductor with circular cross section for illustration of the skin effect;

Fig. 2     shows a first diagram explaining the skin effect;

Fig. 3        shows a first embodiment of a low pass filter device according to the invention;

Fig. 4a       shows a first longitudinal cross sectional view of a low pass filter device according to the invention;

Fig. 4b       shows a second longitudinal sectional view of a low pass filter device according to the invention;

Fig. 5        shows a second diagram illustrating the high frequency damping effect of the low pass filter device according to the invention;

Fig. 6        shows a second embodiment of a low pass filter device comprising a plurality of damping elements according to the invention;

Fig. 7a       shows two conventional conductors arranged in parallel and opposed to each other;

Fig. 7b       shows a first compound low pass filter device comprising a first and a second alternative low pass filter device arranged in parallel and opposed to each other and with interlacing peripheral conducting elements;

Fig. 8a       shows current density distributions of the two conventional conductors according to the device shown in fig. 7a for low AC frequencies;

Fig. 8b       shows current density distributions of the two conventional conductors according to the device shown in fig. 7a for high AC frequencies;

Fig. 9a       shows current density distributions of the two interlacing alternative damping devices according to the device shown in fig. 7b for low AC frequencies;

Fig. 9b       shows current density distributions of the two interlacing alternative damping devices according to the device shown in fig. 7b for high AC frequencies;

Fig. 10a      shows a third diagram illustrating a comparison of the resistance of the inventive low pass filter device and a state of the art device;

Fig. 10b      shows a fourth diagram illustrating a comparison of the inductance of the inventive damping device compared to the state of the art;

Fig. 11       shows a second compound low pass filter device comprising a plurality of low pass filter elements according to the invention;

Fig. 12       shows a third compound low pass filter device according to the invention;

Fig. 13a      shows another compound low pass filter device according to the invention with interlacing peripheral conducting elements;

Fig. 13b      shows yet another compound low pass filter device according to the invention;

The figures 1a to 1d respectively show a cross sectional view of a prior art conductor 1 having a circular cross section. The black regions are regions with high current density. In the figures 1a to 1d the current density is illustrated by black dots. The more dots per inch the higher the current density is. The light, i.e. white, regions are regions with a comparatively low current density. The surface of the regions with high current density decreases with increasing frequency of an alternate current, the current density of which is high in the dark regions and low in the light regions.

Figure 2 depicts, in a first two-dimensional diagram with a horizontal frequency axis F and a vertical resistivity axis R, the frequency dependence of the resistivity of the conductor 1 shown in figure 1. The resistivity increases with the frequency once the frequency rises above a threshold zone at which the skin depth is equal to the conductors 1 radius. The threshold zone is displayed as a rounded portion in figure 2.

Figure 3 shows a low pass filter device 2 according to the invention for damping high frequency alternating current conducted therethrough. The damping device 2 comprises a main conducting portion 3 with a first end 4.1 and a second end 4.2 connected to each other along a main axis 4. The low pass filter device 2 further comprises a peripheral conducting element 5 electrically contacting the main conducting portion 3 and geometrically protruding away from said main conducting portion 3 and from the main axis 4 respectively between the first end 4.1 and the second end 4.2 for high frequency AC damping.

The low pass filter device 2 according to the invention has a plurality of peripheral conducting elements 5 contacting the main conducting portion 3 and protruding away from said main conducting portion 3 and from the main axis 4 respectively between the first end 4.1 and the second end 4.2 for high frequency AC damping.

The peripheral conducting elements 5 are respectively formed as a fin laterally projecting away from the main axis 4. The plurality of peripheral conducting elements 5 are arranged such that a periodic pattern is formed. The damping device 2 is even and extending in a plane comprising the main axis 4. However, in another embodiment not shown herein, the fins can also be placed all around the main conductor, e.g. in that they protrude radially off the main axis 4 about at least an axial portion of the main conducting portion 5 conferring the low pass filter device a brush-like overall appearance. Returning to the embodiment shown in figure 3, the main conducting portion 3 and the peripheral conducting elements 5 are formed by one structural unit. The damping device 2 is punched out of sheet metal. Breadths, lengths, thicknesses of and distances between the peripheral conducting elements 5 are subject to specific demands and applications and are thus designed for meeting specific damping characteristic requirements.

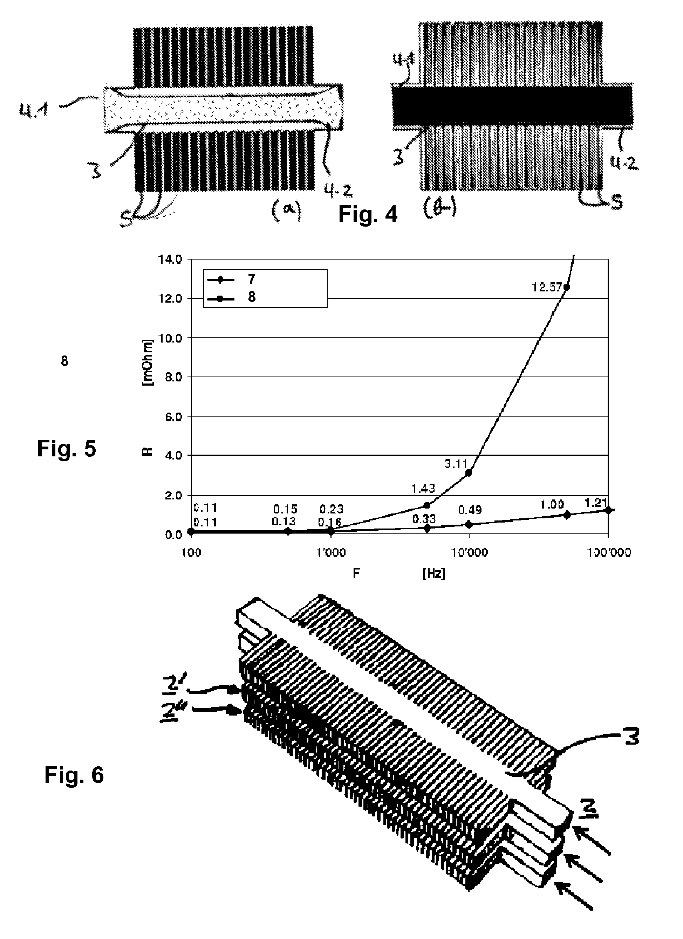

Figure 4 discloses a first sectional view of the damping device 2 on the left side (a) and a second sectional view of the damping device 2 on the right side (b). Here, the dark regions are regions with low current density, while the light regions are regions with high current density. The first sectional view (a) shows current density distribution for a low alternate current (AC) frequency, while the second sectional view (b) shows current density distribution for a high AC frequency.

The results of the current density distribution clearly show that at 100 Hz (low frequency) displayed in figure 4a the current goes straight through the main conducting portion 3 with only slightly lower density in the centre (dotted area). At 10 kHz (high frequency) displayed in figure 4b, the current travels along the lateral conductor surface where the total path length is significantly longer/increased.

As shown in figure 4, at a low AC frequency, the highest current densities are found in the main conducting portion 3 between the first end 4.1 and the second end 4.2, while at a high AC frequency, the highest current densities are found at the periphery of the peripheral conducting elements 5. The current path lengths for the alternate current between the first end 4.1 and the second end 4.2 at a high AC frequency are increased with respect to the current path lengths between the first end 4.1 and the second end 4.2 at a low AC frequency. The total resistivity of the damping device 2 between the first end 4.1 and the second end 4.2 is significantly higher for a high AC frequency as compared to for a low AC frequency.

The resulting resistance increase is displayed in Fig. 5. Design parameters for such fin structures as the fin width, space and lengths influence the total damping increase as well as the cut-off frequency at which the damping starts. Figure 5 is a second two-dimensional diagram showing the high frequency resistance on a 1 metre bus bar. The diagram features a horizontal frequency axis and a vertical resistivity axis showing the dependence of resistivity over frequency for a reference conductor 7 and the low pass filter device 2 according to the invention 8. As can be seen, the resistivity increase due to frequency increase is significantly higher for the inventive low pass filter device 2 according to the invention (bullet line) than for the known reference conductor (diamond line). At high AC frequencies the resistivity of the inventive low pass filter device 2 according to the invention is more than ten times higher than the resistivity of the known reference conductor.

In multi phase bus bars being multi phase damping devices according to the invention (e.g. 3-phase systems, or DC plus/minus systems), the actual damping requirements depend on the application and the noise type expected. Common mode (CM) noise and differential mode (DM) noise must be damped differently.

The common mode (CM) is the easier case, since it is very similar to the single line bus bar being a damping device according to the invention. The skin effect of common mode noise along three parallel bus bars behaves as in a single bus bar (Fig. 6).

In figure 6 the low pass filter device 2, together with a second low pass filter device 2' and a third low pass filter device 2'', forms a first stack of damping devices 2, 2', 2'' according to the invention respectively serving as damping elements according to the invention. The stack may be used a first compound low pass filter device. With such a stack of damping devices 2, 2', 2'' according to the invention, a plurality of parallel AC-lines may be high frequency damped. As indicated by the arrows, the plurality of damping devices 2, 2', 2'' pointing in the direction of the main axis have the same current direction.

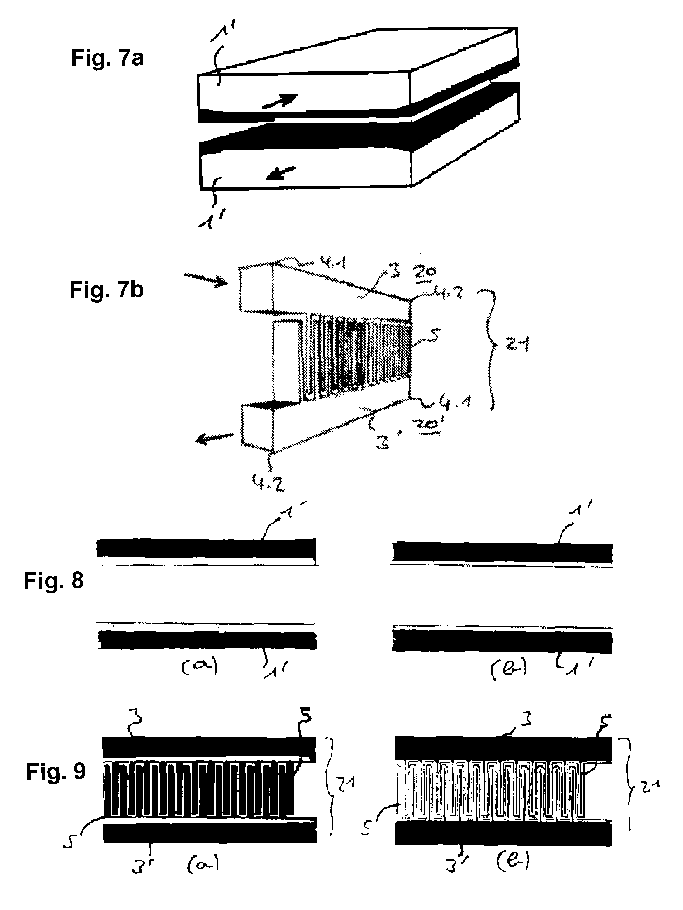

The differential mode case changes the situation and demands for a slightly different approach. In low pass filter compound devices comprising conductors that are arranged one to another in parallel but with opposing current directions, the currents are attracted towards each other with a resulting high frequency current density distribution shown in Fig. 7a). The direction of the current flow is indicated by arrows at the front end of the two conductor bars. In order to achieve the same HFD effect, the peripheral conducting elements must therefore be placed between the two bus bars such as shown in Fig. 7b. This might imply to spread the bars more than usual in order to have enough space for the fin structure.

In figure 7(a) two conventional conductors 1' arranged in parallel and opposed to each other are shown. As indicated by the arrows, the two conventional conductors 1' have anti-parallel current directions. As in figure 1, the dark regions are regions with high current density, while the light regions are regions with low current density. The current path lengths along the conventional conductors 1', however, are short. The total resistivity for high frequency alternate currents is small.

In figure 7 (b) a first alternative damping device 20 and a second alternative low pass filter device/damping device 20' - respectively serving as damping elements according to the invention - respectively having a plurality of peripheral conducting elements 5 form a first compound damping device 21 with interlacing but spaced apart - which means non contacting - peripheral conducting elements 5. In this case, as in general, an insulator may be put between neighboring and/or adjacent peripheral conducting elements 5 from one or different damping devices.

Simulation results for the differential mode case show that the same HFD effect can be achieved. Fig. 8 shows the current density distribution at 100 Hz (Fig. 8 (a)) and 10 kHz (Fig. 8 (b)) for two straight conductors with opposing current direction such as shown in Fig. 7a and Fig. 7b respectively. In the 10 kHz case, the surface current at the fins is clearly visible and is displayed in a shimmering style along the outline of the fins in figure 9b.

As already done in figure 4, the dark regions in the figures 8 and 9 represent regions with a low current density, while the light regions are regions with high current density. Fig. 9 shows the current density distribution at 100 Hz (Fig. 9 (a)) and 10 kHz (Fig. 9 (b)) for bus bars with interlaced peripheral conducting elements. The current at 100 Hz has the same density as in the straight embodiment, i.e. as in the main conducting portion 3. At 10 kHz however, the current enters the narrow fins thereby increasing the total path length and thus the ohmic resistance. For low AC frequencies (figs. 8 (a) and 9 (a)), the high current densities are present at the peripheral regions of the alternative conventional conductors 1' or main conducting portions 3 facing the respective other conventional conductor 1' or main conducting portion 3. For high AC frequencies (figs. 8(b) and 9 (b)), however, high current densities are present at the peripheral regions of the alternative conventional conductors 1' facing the respective other conventional conductor 1' and at the peripheral regions of the peripheral conducting elements 5 facing the respective other peripheral conducting elements 5.

For low AC frequencies, the current path lengths along the alternative conventional conductors 1' are similar to the current path lengths along the main conducting portions 3. For high AC frequencies, however, the current path lengths along the peripheral conducting elements 5 of the damping devices - indicated by light/white or shimmering regions in fig. 9b - are significantly longer than the current path lengths along the alternative conventional conductors 1' - light regions in fig. 8b.

Thus, for low AC frequencies, the total resistivities of both cases are similar, while the total resistivities of the different cases differ significantly for high AC frequencies. For high AC frequencies, the total resistivity of the compound low pass filter device 21 with the interlacing first alternative damping device 20 and second alternative damping device 20', is much higher than in the compound system with the two alternative conventional conductors 1'.

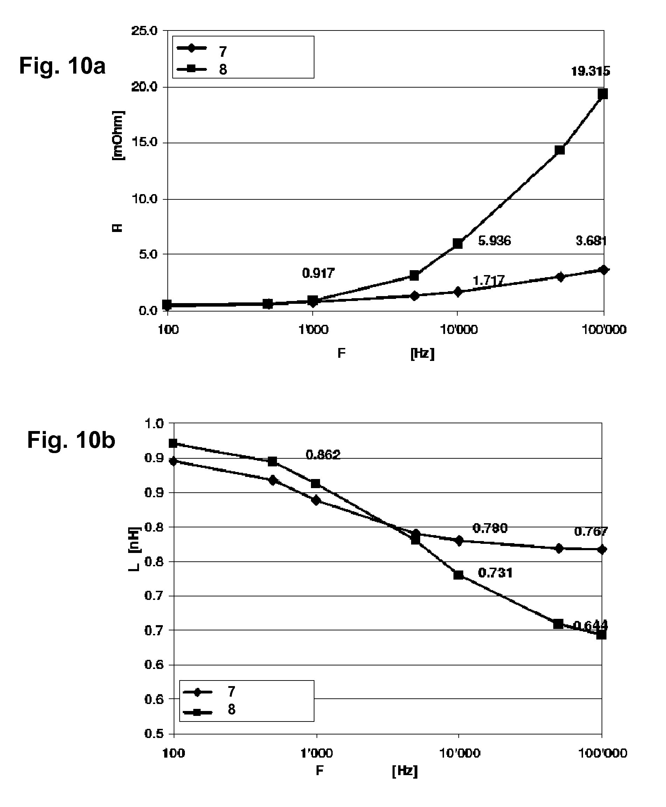

The twin-set of figures 10 are diagrams showing a comparison of the HF resistance on a one meter bus bar. As in figure 5 the diagram shows the plotted bus bar resistances and inductances for the two cases, i.e. the inventive low pass filter device and a known/ prior art reference device. Again, a significant resistance increase can be observed, even for a non-optimized fin-structure.

Figure 10(a) shows a third two-dimensional diagram with an horizontal frequency axis and a vertical resistivity axis showing the dependence of resistivity over frequency for the reference system with the two alternative conventional conductors 1" and for the first inventive compound low pass filter device 21 with the interlacing first alternative damping device 20 and second alternative damping device 20'. The two alternative conventional conductors 1' are responsible for the diamond line 7 whereas the inventive compound low pass filter device 21 led to the quad line 8. In both cases, the resistivity increases with increasing AC frequency. This increase, however, is significantly higher for the inventive first compound damping device 21 (line 8) than for the reference system with the two alternative conventional conductors 1' (line 7). At high AC frequencies the resistivity of the compound low pass filter device 21 is more than five times higher than the resistivity of the reference system.

In figure 10(b), a fourth two-dimensional diagram with an horizontal frequency axis and a vertical inductivity axis showing the dependence of inductivity over frequency for the reference system with the two alternative conventional conductors 1' and for the inventive first compound low pass filter device 21 with the interlacing first alternative damping device 20 and second alternative damping device 20' is shown. The two alternative conventional conductors 1' are responsible for the diamond line 7 whereas the inventive compound low pass filter device 21 led to the quad line 8. In each case, the inductivity decreases with increasing AC frequency. Although the diminution of inductivity is more pronounced for the first compound damping device 21 (line 8) than for the reference system with the two alternative conventional conductors 1' (line 7), in both cases the inductivity remains in the same order of magnitude. The inductivity is thus approximately constant.

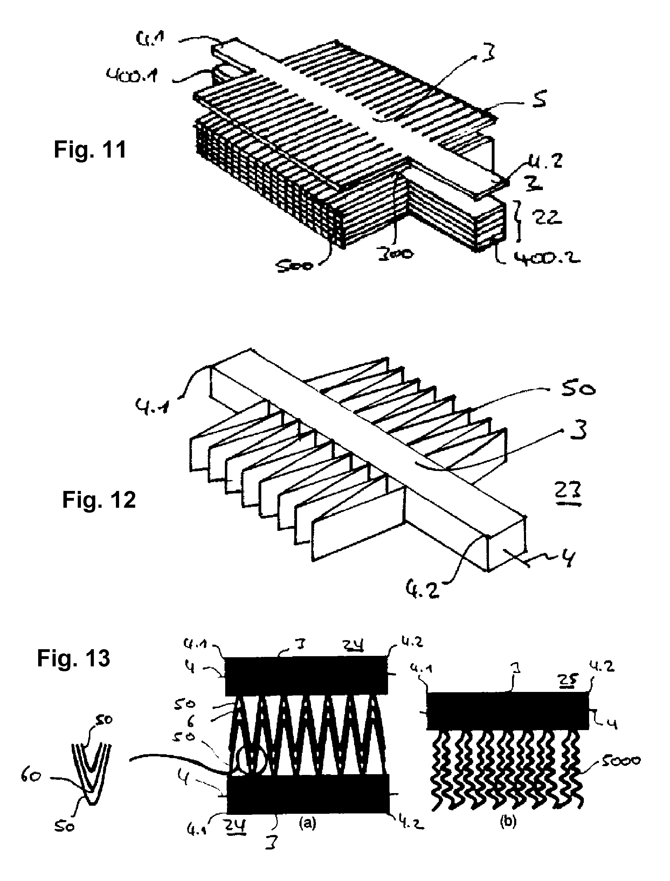

As an alternative to the first compound low pass filter device 21 with interlacing peripheral conducting elements 5 depicted in figure 7, figure 11 shows a second compound low pass filter device 22 formed by a plurality of stacked low pass filter devices 2 respectively serving as damping elements according to the invention. The main conducting portions 3, the first ends 4.1, the second ends 4.2 and the peripheral conducting elements 5 form a compound main conducting portion 300, a compound first end 400.1, a compound second end 400.2 and compound peripheral conducting elements 500 respectively. The compound peripheral conducting elements 500 contact the compound main conducting portion 300 and protrude laterally away from the compound main conducting portion 300 respectively between the compound first end 400.1 and the compound second end 400.2 for high frequency AC damping. The second compound damping device 22 behaves analogously as the compound device 2 as shown in figure 4.

Economic manufacturing is a critical aspect of the low pass filter devices according to the invention. The density of peripheral conducting elements and the resulting structures typically increases the manufacturing costs. Several options are proposed here on how to produce damping devices according to the invention. The first method is applicable to single damping devices or damping elements or to CM damping devices or damping elements. The idea is to laminate thin punched conductor layers to reach to a total final thickness (Fig. 11). Punched sheets are cheap to produce and if the lamination is in the current flow direction, no DC-resistance increase is introduced. The laminated sheet metal can be held together by screws in addition to or instead of the lamination, for example.

The second method is to attach folded metal sheets to the existing bus bar (Fig. 12). The attachment can be done by soldering, welding or brazing. This method is more flexible than the first in terms of the degree of design freedom of the fins and can also be applied to DM damping bus bars. In the differential mode (DM) case, the folded sheet metal can be a conductor insulator-conductor stack in order to include the high voltage insulation layer where required (Fig. 13a). Furthermore, by using more complex folding shapes (Fig. 13.b), the total high frequency current paths can be increased to achieve an even higher damping effect.

Figure 12 shows further alternative low pass filter devices 23 according to the invention comprising a main conducting portion 3 with a first end 4.1 and a second end 4.2 connected by a main axis 4. As peripheral conducting elements contacting the main conducting portion 3 and protruding away from said main conducting portion 3 and the main axis 4 respectively between the first end 4.1 and the second end 4.2 for high frequency AC damping, the further alternative low pass filter device 23 comprises first alternative peripheral conducting elements 50 formed as folded metal sheets that are electrically connected to the main conducting portion 3.

In figure 13(a), two fourth alternative low pass filter devices 24 - respectively serving as damping elements according to the invention - each having a main conducting portion 3 with a first end 4.1 and a second end 4.2 connected by a main axis 4 and a first alternative peripheral conducting element 50 being meander-shaped are shown. The two fourth alternative damping devices 23 are arranged in parallel and opposed to each other. The two fourth alternative low pass filter devices 23 have interlacing first alternative peripheral conducting elements 50 between which an insulator 6 is arranged. The two fourth alternative low pass filter devices 23 further have anti-parallel current directions.

In figure 13(b) a fifth alternative low pass filter device 25 is shown, having a main conducting portion 3 with a first end 4.1 and a second end 4.2 connected by a main axis 4 and a second alternative peripheral conducting element 500 being strongly meander-shaped.

In each of the cases shown in the figures 3, 4, 6, 7, 9, 11, 12 and 13, the current densities for high frequency alternate currents at high AC frequencies are highest at the peripheral regions of the respective damping devices 2, 2', 2'', 20, 21, 22, 23, 24, 25 - that is at the peripheral regions of the peripheral conducting elements 5, 50, 500 - according to the invention. Also, in each of the cases shown in the figures 3, 4, 6, 7, 9, 11, 12 and 13, the current paths for currents going from one end (4.1, 4.2) to another end (4.2, 4.1) at high AC frequencies are longer than in cases without the peripheral conducting elements 5, 50, and/or 500 for high frequency AC damping. Accordingly, the respective total resistivities for high frequency alternate currents are increased with the peripheral conducting elements 5, 50, and/or 500.

The invention has been described in detail with particular reference to exemplary embodiments thereof. However, the subject matter of the invention is not limited to these references, embodiments and examples.

In order to adapt the advantageous effects of the subject matter of the invention, the peripheral conducting elements used may be of different types. Geometries, shapes and dimensions may be varied to meet specific requirements according to specific applications. A plurality of peripheral conducting elements may comprise different types of peripheral conducting elements. A specific mixture of types of peripheral conducting elements may be chosen to meet specific requirements of specific applications. A periodic pattern can still be realized in such cases, since pluralities of same types may be arranged such that a more complex periodic pattern is realized. In a case, where a plurality of pluralities of peripheral conducting elements is used, the pluralities of peripheral conducting elements used may be equal or different. The pluralities used may be arranged such that a periodic pattern on a higher level is realized. Preferred types of peripheral conducting elements are fin-shaped and/or meander-shaped peripheral conducting elements with geometries and sizes adapted to effectively damp selected frequencies and/or frequency ranges. The peripheral conducting elements and the main conducting portions may form one integral unit or only be conductively connected to each other; e.g. by welding, brazing, plugging, screwing or the like. A laminated compound low pass filter device as shown in fig. 11 further using glue or other suitable adhesive bonding techniques may also be used. Both, the main conducting portions and/or the peripheral conducting elements, whether as one unit or two connected units, may be punched out or cut by a laser cutter. Both, the main conducting portions and/or the peripheral conducting elements, may be of same or different conducting materials. Instead of flat conducting portions and/or the peripheral conducting elements extending in a plate, non-flat conducting portions and/or the peripheral conducting elements may be used, e.g. by use of bent sheets.

In each case, however, the peripheral conducting elements are used to significantly increase the current path length for high frequency currents and thus the total resistivity for high frequency alternate currents between the first ends and the second ends, without significantly increasing the current path length and thus the total resistivity for low frequency alternate currents between the first ends and the second ends. The high frequency damping quality of the low pass filter devices according to the invention is thus increased.

In addition the peripheral conducting elements lead to increasing cooling surfaces for the damping devices. A melting of elements is avoided. The peripheral conducting elements work well together with both natural and enforced convection effects of a fluid (cooling gas and/or cooling liquid). The heat energy resulting from the high frequency damping can thus easily be carried away. The longevity of devices using the damping devices according to the invention - respectively usable as damping elements according to the invention- is thus increased.

A preferred use of the high frequency damping device or means according to the invention or the description is a use in an electric power device such as for example an electrical power converter. In one embodiment, the electrical power converter may have a connection. The power converter comprises a transformer outlet and a low frequency alternating current terminal which are electrically connected by the at least one high frequency damping device. The low frequency alternating current terminal is designed for supporting AC frequencies in the range between 50Hz and 60Hz. The low pass filter device or means is perfectly suited for at least partially damping switching harmonics occurring in connection with the transformer outlet, which may for example be found at a typical frequency of about 1 kHz.

**Claims**

1. Low pass filter device for damping high frequency alternating current conducted therethrough by means of a mechanical damping means, the damping means(2, 2', 2", 20, 21, 22, 23, 24, 25) comprising:

   - a main conducting portion (3, 300) with

      - a first end (4.1, 400.1) and
      - a second end (4.2, 400.2) connected by
      - a main axis (4) and

   - at least one peripheral conducting element (5, 50, 500, 5000) electrically contacting the main conducting portion (3, 300) and protruding away from said main conducting portion (3, 300) respectively between the first end (4.1, 400.1) and the second end (4.2, 400.2) for high frequency AC damping.

2. Low pass filter device according to claim 1, **characterized in that,** the main conducting portion (3, 300) is connected to a plurality of peripheral conducting elements (5, 50, 500, 5000) electrically contacting the main conducting portion (3, 300) and protruding away from said main conducting portion (3, 300) respectively between the first end and the second end.

3. Low pass filter device according to claim 2,

**characterized in that,** the plurality of peripheral conducting elements (5, 50, 500, 5000) is arranged along the main axis (4) such that a periodic pattern is formed.

4. Low pass filter device according to one of the claims 1 to 3, **characterized in that,** at least one peripheral conducting element (50, 5000) is meander-shaped.

5. Low pass filter device according to one of the claims 1 to 4, **characterized in that,** at least one peripheral conducting element (5, 500) is formed as a fin radially projecting away from the main axis (4).

6. Low pass filter device according to one of the claims 1 to 5, **characterized in that,** the damping device (2, 2', 2", 20, 21, 22, 23, 24, 25) extends essentially in a plane comprising the main axis.

7. Low pass filter device according to one of the claims 1 to 6, **characterized in that,** the damping means is at least partially integrated into the damping device.

8. Low pass filter device according to one of the claims 1 to 7, **characterized in that,** the main conducting portion (3, 300) and the peripheral conducting element are formed by one unit.

9. Low pass filter device according to one of the claims 1 to 7, **characterized in that,** the main conducting portion (3) and the peripheral conducting element (50, 5000) are separate structural units.

10. Low pass filter device according to claim 9, **characterized in that,** the peripheral conducting element (50, 5000) comprises at least one zigzag shaped conductor sheet.

11. Low pass filter device according to one of the claims 1 to 10, **characterized in that,** the damping device (21, 22) consists of a plurality of damping elements (2, 2', 2").

12. Low pass filter device according to claim 11, **characterized in that,** the damping device (22) is formed by a stack of damping elements (2, 2', 2'' , 20, 20') according to the invention.

13. Low pass filter device according to claim 11, **characterized in that,** the damping device (21) comprises a plurality of damping elements (20, 20') with interlacing peripheral conducting elements (5).

14. Electric power device comprising at least one low pass filter device according to any one of claims 1 to 13 that is conductively connected to at least one of an electric and an electronic element.

15. Electric power device comprising according to claim 14, **characterized in that,** the at least one electric device comprises a transformer outlet and a low frequency alternating current terminal which are electrically connected by the at least one low pass filter device.

16. Electric power device comprising according to claim 14, **characterized in that,** the at least one electric device comprises a power electronic inverter direct current outlet and a direct current link capacitor, which are electrically connected by the at least one low pass filter device.

**Fig. 1**  (a)  (b)  (c)  (d)

**Fig. 2**

**Fig. 3**

**Fig. 4**

(a)   (b)

**Fig. 5**

**Fig. 6**

**Fig. 7a**

**Fig. 7b**

**Fig. 8**

**Fig. 9**

Fig. 10a

Fig. 10b

**Fig. 11**

**Fig. 12**

**Fig. 13**

EP 2 284 997 A1

Europäisches Patentamt
European Patent Office
Office européen des brevets

**EUROPEAN SEARCH REPORT**

Application Number

EP 09 16 5418

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 806 841 A (BRUNNER R) 23 April 1974 (1974-04-23) * column 1, lines 6-15; figures 1,2,4 * * column 2, lines 3-67 * * column 3, line 32 - column 4, line 31 * * column 6, lines 17-55 * ----- | 1-16 | INV. H03H1/00 H03H7/01 H01P1/201 H01P1/22 |
| X | US 5 883 565 A (FURINO JR JAMES P [US]) 16 March 1999 (1999-03-16) * column 1, line 58 - column 2, line 10 * * column 3, line 3 - column 4, line 25 * * claims 10-17; figures 1-3 * ----- | 1-16 | |
| A | FERREIRA J A ET AL: "Sources, paths and traps of conducted EMI in switch mode circuits" THIRTY-SECOND ANNUAL MEETI NG INDUSTRY APPLICATION SOCIETY, IEEE, vol. 2, 5 October 1997 (1997-10-05), - 9 October 1997 (1997-10-09) pages 1584-1591, XP010248532 * left-hand column, paragraph 2 - page 1586 * ----- | 1-16 | |
| A | DUCLUZAUX A: "Extra losses caused in high current conductors by skin and proximity effects" SCHNEIDER ELECTRIC - CAHIER TECHNIQUE, no. 83, 2002, pages 1-20, XP007910601 * sections 2,3 * ----- | 1-16 | TECHNICAL FIELDS SEARCHED (IPC) H01B H02M H01C H03H H01P |

The present search report has been drawn up for all claims

| Place of search | Date of completion of the search | Examiner |
|---|---|---|
| Munich | 27 November 2009 | Maget, Judith |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 16 5418

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2009

| Patent document cited in search report | | Publication date | Patent family member(s) | | Publication date |
|---|---|---|---|---|---|
| US 3806841 | A | 23-04-1974 | CA | 1003915 A1 | 18-01-1977 |
| US 5883565 | A | 16-03-1999 | JP | 2002502556 T | 22-01-2002 |
| | | | WO | 9921244 A1 | 29-04-1999 |
| | | | US | 5999080 A | 07-12-1999 |

EPO FORM P0459

For more details about this annex : see Official Journal of the European Patent Office, No. 12/82